# EUROPEAN PATENT SPECIFICATION

(11) **EP 2 176 952 B1**
(45) Date of publication and mention of the grant of the patent: **06.06.2012**
(21) Application number: 08775296.0
(22) Date of filing: 23.07.2008
(51) Int. Cl.: H03K 3/011, H03K 3/0231, H03L 1/00, H03L 7/02, H03L 7/097

(54) **DIGITAL CONTROLLED OSCILLATOR**
DIGITAL GESTEUERTER OSZILLATOR
OSCILLATEUR À COMMANDE NUMÉRIQUE

(30) Priority: 23.07.2007 DE 102007034186; 26.12.2007 US 16743
(43) Date of publication of application: 21.04.2010
(73) Proprietor: TEXAS INSTRUMENTS DEUTSCHLAND GMBH, 85356 Freising (DE)
(72) Inventor: VANSELOW, Frank, 85395 Attenkirchen (DE); ARNOLD, Matthias, 85354 Freising (DE)
(74) Representative: Holt, Michael
(86) International application number: PCT/EP2008/059626
(87) International publication number: WO 2009/013301

(56) References cited:
- US-A- 3 688 211
- US-A- 5 343 169
- US-A- 5 881 374
- US-A1- 2002 041 217
- US-A1- 2002 121 940
- US-A1- 2007 103 244
- US-B1- 6 614 318

## Description

The present invention generally relates to an electronic device with a digital controlled oscillator (DCO).

Fully integrated RC oscillators are limited in performance compared to oscillators that use a high Q resonator, as for example crystal oscillators. Initial frequency accuracy, frequency drift over temperature and voltage and phase noise are always worse in fully integrated oscillators than in an oscillator comprising a high Q resonator. However, it is desirable to use RC oscillators instead of crystal oscillators, as they can be fully integrated In a CMOS technology, which reduces complexity and production costs.

United States Patent No. 6614318 describes a phase controller coupled to a voltage-controlled oscillator (VCO) in a feedback configuration so as to reduce the phase noise introduced by the VCO. The phase controller measures successive actual periods of the VCO output clock, and in response, generates a control voltage representative of deviations in the successive actual periods of the VCO output clock. The phase controller transmits the control voltage to the VCO as a feedback control voltage and adjusts the actual period of the VCO output clock in response to the control voltage. More specifically, the VCO adjusts the actual period of the VCO output clock such that deviations in the successive actual periods of the VCO output clock are reduced.

It is an object of the present invention to provide an electronic device including a digital oscillator with an improved accuracy and long term stability of the oscillation frequency.

Accordingly, the present invention provides a digital controlled oscillator as set out in the appended claims. The digital controlled oscillator includes a programmable current source, a first variable capacitor, and a second variable capacitor. A comparator is provided for comparing the voltage drop across the variable capacitors with a reference voltage level, and for providing a DCO output clock signal. A switching means alternately switches the variable capacitors to receive either a current from the programmable current source or to be discharged in response to an output signal of the comparator. Further, a clock divider is coupled to the comparator output for dividing the DCO output clock signal by a factor N, which is substantially greater than 1, in order to provide a divided clock signal. Further, a frequency monitoring stage is provided for receiving the divided clock signal. The frequency monitoring stage is adapted to determine the time difference of successive clock periods of the divided clock signal and to generate a feedback signal based on the determined time difference. The DCO is coupled to the feedback signal for adjusting the DCO output clock frequency in response to the feedback signal. An advantageous way of adapting the DCO frequency consists in adapting the capacitance values of the variable capacitors with the feedback signal. Preferably, the factor N is chosen such that a period of the divided clock signal is in proportion to a temperature, supply voltage or other degradation induced deviation of the DCO output clock signal. Advantageously, the monitoring stage is adapted to compare pairs of consecutive divided clock periods, such that each divided clock period is compared with a preceding divided clock period and with a following divided clock period. This ensures continuous, consistent and reliable control.

In a conventional DCO architecture, component properties, as for example resistances, capacitance values, delay times as well as comparator offset voltages etc. are temperature and supply voltage dependent. Even with a high-precision reference voltage or current generator (e.g. bandgap reference voltage source) the achievable overall accuracy of the oscillator will be in a range of only 2% to 5%. The initial oscillator frequency can be trimmed easily by various means. For example, the reference current or the capacitors can be changed by a trimming scheme. However, to get the overall accuracy of the oscillator in the range of a crystal oscillator (e.g. 20 to 50 ppm), further improvements are required. Accordingly, the present invention suggest to choose the factor N in accordance with a temperature deviation, and/or a supply voltage induced deviation or any similar slow deviation that is to be compensated. As long as the deviation is relatively slow compared with the oscillating frequency, the present invention provides a convenient, easy and effective means, so that the oscillator output frequency is scaled to the frequency deviation. It is therefore a special aspect of the invention to scale down a DCO output frequency in a range where a clock frequency of a downscaled clock signal can be used as an indicator for a frequency deviation, which is much slower than the DCO clock frequency. The way to determine the frequency deviation is differential and self-regulating, which means that successive clock periods of the downscaled clock are compared with each other and the comparison result is used to adjust the DCO frequency.

Preferably, the frequency monitoring stage comprises an adjustable current source, three calibration capacitors, a comparator, switching means to alternately couple one of the three calibration capacitors to the adjustable current source, and two of the three calibration capacitors to the second comparator, in order to compare the voltage levels on the calibration capacitors. A controlling means is provided for controlling the switching means such that either one of the calibration capacitors is successfully charged with the current from the adjustable current source over a period of the divided clock signal to a respective maximum voltage level. Two maximum voltage levels are then consecutively selected and compared by the comparator in each clock period of the divided clock. A reference signal is generated by a voltage ramp. This voltage ramp is sampled by the oscillator output signal. The difference in amplitude of two successive samples is a measure of the frequency drift or change and is used as an input for a digital control block implemented by the controlling means. The output of the control block then controls the three calibration capacitors. To optimize the tuning process, the digital control block can use an algorithm (e.g. a search algorithm), for example a binary weighting scheme. In this way, both coarse and fine tuning of the feedback loop can be efficiently, achieved.

Preferably, the device further comprises a weighting stage coupled between the output of the second comparator and the variable capacitors of the digital controlled oscillator for weighting the output signal of the second comparator. This weighting stage can include a counter, which is increased and decreased in response to the comparator output. The counter can be an up-and-down counter, such that if the voltage difference is positive, the counter value is increased by 1, but if the voltage difference is negative, the counter value will be decreased by 1. The output of the counter or an average value thereof then controls the capacitive array by adjusting the capacitance of the first and second capacitors up or down so as to compensate for frequency drift of the output signal of the DCO. Although it is preferred to adjust the capacitance of the DCO, other ways to adjust the DCO frequency are generally conceivable, like e.g. adjusting a current in the DCO or a resistor.

Preferably, each of the variable capacitors comprises two portions. In the first portion, the capacitance is adjusted in response to the feedback signal, and in the second portion there is a constant capacitance value. This means that the fine tuning of the DCO output clock signal can be achieved by varying the capacitance of the variable capacitors around their constant value.

The present invention also provides a method for adjusting the oscillation frequency of a digital controlled oscillator. The method comprises dividing the frequency of the output clock signal of the DCO, comparing the length of successive periods of the divided clock signal, and adjusting the output clock frequency of the DCO in response to the comparison result. The frequency drift of the DCO is mainly caused by limited power supply rejection (PSRR) of the oscillator and temperature/voltage drift of component parameters. Therefore, the present invention suggest to establish a self-control mechanism, wherein the instantaneous frequency of the DCO oscillating frequency is determined in successive points in time. The difference of these measurement results (i.e. the difference of the length or duration of the different periods) is directly proportional to the frequency change and is advantageously used in a control loop to reduce the error. Advantageously, a variable capacitor in the DCO can be adjusted for tuning the frequency. Further, always pairs of consecutive clock periods of the divided clock signal can be compared, and firstly, a first clock period of the divided clock signal is compared with a second clock period and next the second clock period is compared with a third clock period. Accordingly, each clock period of the divided clock signal is compared with a predecessor and a successor before it is dismissed from being monitored, which provides a continuous and reliable control. The method of the present invention provides the advantage that the scheme is not using an amplitude control loop or phase locked loop scheme, where the oscillating frequency is compared with a reference signal. Instead, the circuit is using a mainly digital tuning and trimming scheme in a feedback configuration, thereby establishing a self-controlling DCO. It allows a very simple and area-efficient implementation of a fast acquisition scheme, due to the mainly digital realization of the circuitry. No complex low-frequency analogue filters are required for the control loop. Furthermore, the present invention provides the advantages of a reliable operation. An area-efficient implementation is also provided, which has a wide operating frequency range (e.g. 100 kHz - 40 MHz). Additionally, the adjustable current source providing current for the three capacitors can be implemented so as to be adjustable on the basis of the resistance of a single resistor. If such a resistor is implemented externally, i.e. not integrated with the other components on the same die, the high accuracy of the device depends only on an external resistor and can be easily adjusted.

Further characteristics and advantages of the invention ensue from the description below of a preferred embodiment, with reference to the accompanying drawings, in which:
- Figure 1 is a simplified circuit diagram of a digital controlled oscillator for use in the device according to a first embodiment of the invention;
- Figure 2 is a simplified circuit diagram of a device according to a second embodiment of the invention;
- Figure 3 is a schematic diagram of frequency and voltage against time for the device of the present invention under stable conditions; and
- Figure 4 is a schematic diagram of frequency and voltage against time for a device according to the present invention under unstable conditions, for example due to temperature drift.

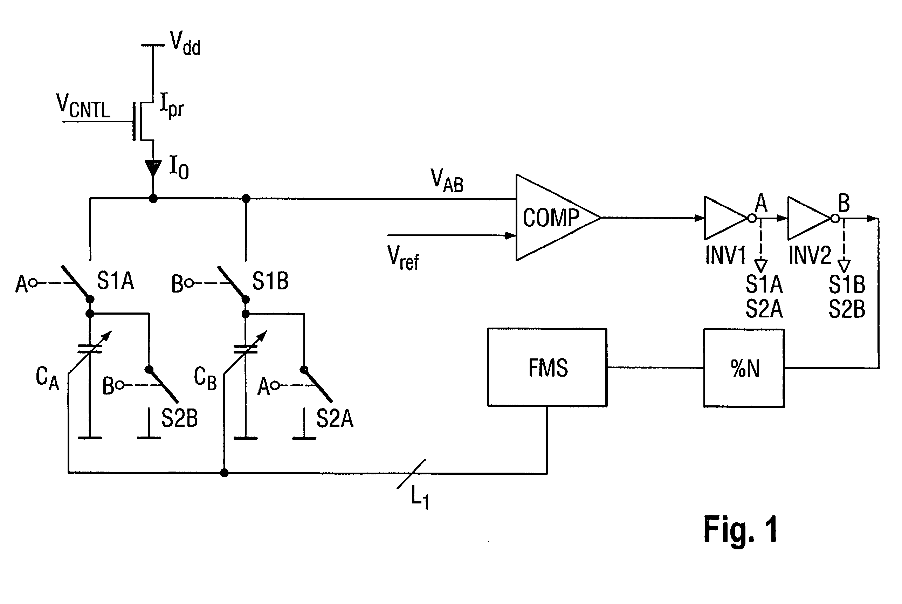

Figure 1 shows a digital controlled oscillator (DCO) as part of the device according to the invention. A programmable current source Ipr, which is implemented as a MOS transistor, is connected between a supply voltage rail Vdd and a voltage rail V_{AB}, and is adapted to provide a reference current I₀. The gate terminal of the MOS transistor implementing the current source Ipr is operable to receive a control voltage V_{CNTL}. The voltage rail V_{AB} forms one input of a comparator COMP. The other input of the comparator COMP is provided by a reference voltage Vref. The output of the comparator COMP is connected to an inverter INV1, which is connected in series with another inverter INV2. The output of the inverter INV2 is connected to a divide by N clock divider %N and the clock divider %N is coupled to a frequency monitoring stage FMS. The frequency monitoring stage FMS is connected to a bus L1. The inverter INV1 is configured to output a first control signal A and the inverter INV2 is configured to output a second control signal B, which is the inverse of the control signal A.

Two capacitors C_{A} and C_{B} are connected in parallel with each other between the voltage rail V_{AB} and ground, via respective switches S1A and S1B. Both capacitors C_{A} and C_{B} are also connected to the bus L1, the signal from which is operable to vary the capacitance of the capacitors C_{A} and C_{B}. The capacitor C_{A} is also connected in parallel with a switch S2B and the capacitor C_{B} is connected in parallel with a switch S2A, such that the switches S2A and S2B are both connected to ground. The switch S2A is also connected to a node interconnecting the switch S1B and the capacitor C_{B} and the switch S2B is connected to a node interconnecting the switch S1A and the capacitor C_{A}. The switches S1A and S2A are operable to be controlled by the signal A output from the inverter INV1 and the switches S1B and S2B are operable to be controlled by the signal B output from the inverter INV2. The switches can be implemented, for example, by MOS transistors.

In operation, the comparator COMP compares the voltage drop across the variable capacitors C_{A} and C_{B} at the voltage rail V_{AB} with the reference voltage Vref. The output of the comparator COMP is then the DCO output clock signal, which is generated based on the difference between the voltage V_{AB} and the reference voltage Vref. If the voltage at the voltage rail V_{AB} is greater than the reference voltage Vref, the output of the comparator COMP will be positive, which means that the output signal A output from the inverter INV1 is negative and the output signal B output from the inverter INV2 is positive. This means that the switches S1A and S2A are opened and the switches S1B and S2B are closed, such that the capacitor C_{A} discharges to ground via the closed switch S2B and the capacitor C_{B} is charged by the reference current I₀. When the voltage at the voltage rail V_{AB} becomes less than the reference voltage Vref, the output of the comparator is negative and the opposite of the above occurs, so that the output signal A is positive and the signal B is negative. Switches S1A and S2A are closed and switches S1 B and S2B are opened so that the capacitor C_{B} discharges to ground via the closed switch S2A and the capacitor C_{A} is charged by the reference current I₀. Thus the capacitors C_{A} and C_{B} are alternately switched to receive either a current I₀ from the programmable current source Ipr or to be discharged and the DCO periodically toggles between charging and discharging of the capacitors C_{A} and C_{B}, which generates the output frequency of the DCO.

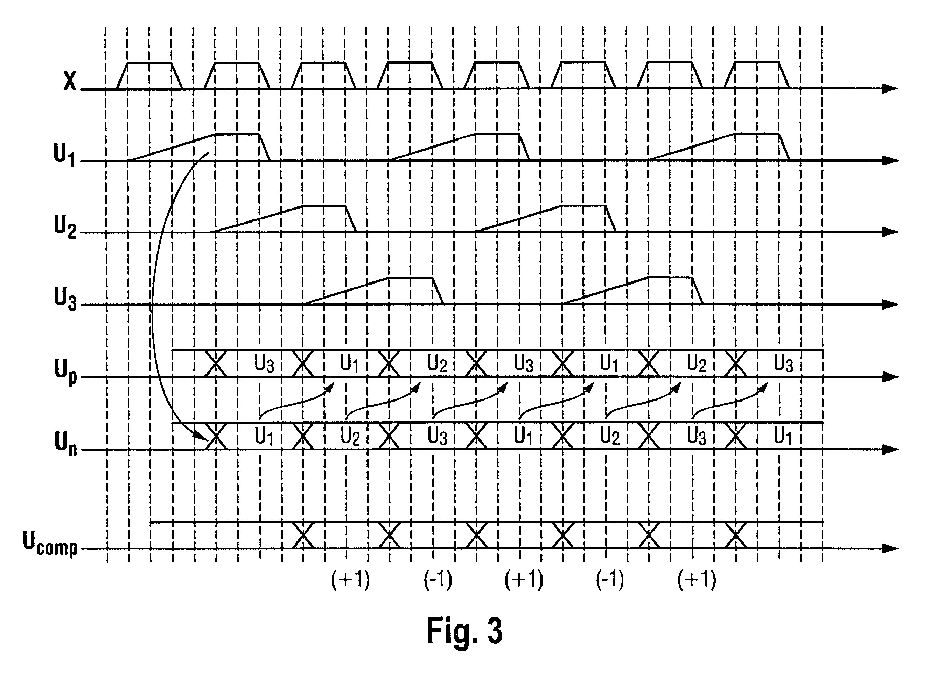

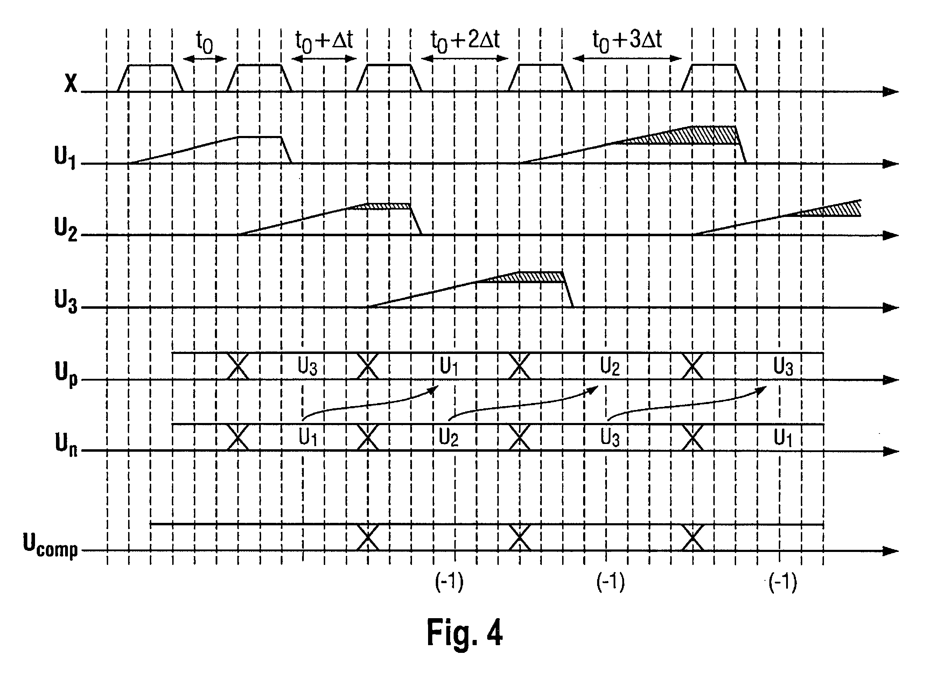

Ideally, the output frequency of the DCO should look like the uppermost diagram in Figure 3, which shows the divided output frequency X (as divided by the clock divider %N at the output of the comparator COMP) against time under stable conditions. In other words, the output of the DCO should be a regular periodic output signal with no frequency drift. However, any temperature changes can cause the frequency to drift so that the time period between successive output signals becomes longer and longer and the divided output frequency X against time looks like that shown in the top graph in Figure 4. The required time period between output signals is to, which is the time gap between the first two signals. By the time the third signal is output, the time period between the second and third output signals has increased to to + Δt, then between the third and fourth output signals to to + 2Δt, and so on, increasing by an amount Δt after every consecutive output signal. To prevent this frequency drift, the clock divider %N is configured such that the factor N divides the output of the comparator COMP; i.e., the output frequency of the DCO, so that the period of the divided clock signal is chosen so as to compensate a temperature or supply voltage induced deviation of the DCO output clock signal. Generally, the control loop established through divider %N, the frequency monitoring stage FMS and the adjustable capacitors has a characteristic (delay, settling time, frequency response etc.), which provides a stable feedback control, but in proportion to a specific frequency deviation relating to a temperature or supply voltage. The frequency monitoring stage FMS then receives the divided clock signal X and determines the time difference of successive clock periods of the divided clock signal X. Based on the determined time difference, the frequency monitoring stage generates a feedback signal in response to the determined time difference. The feedback signal then adjusts the capacitance values of the variable capacitors CA and CB either up or down to compensate for the time difference, which corrects the frequency drift of the signal output from the DCO.

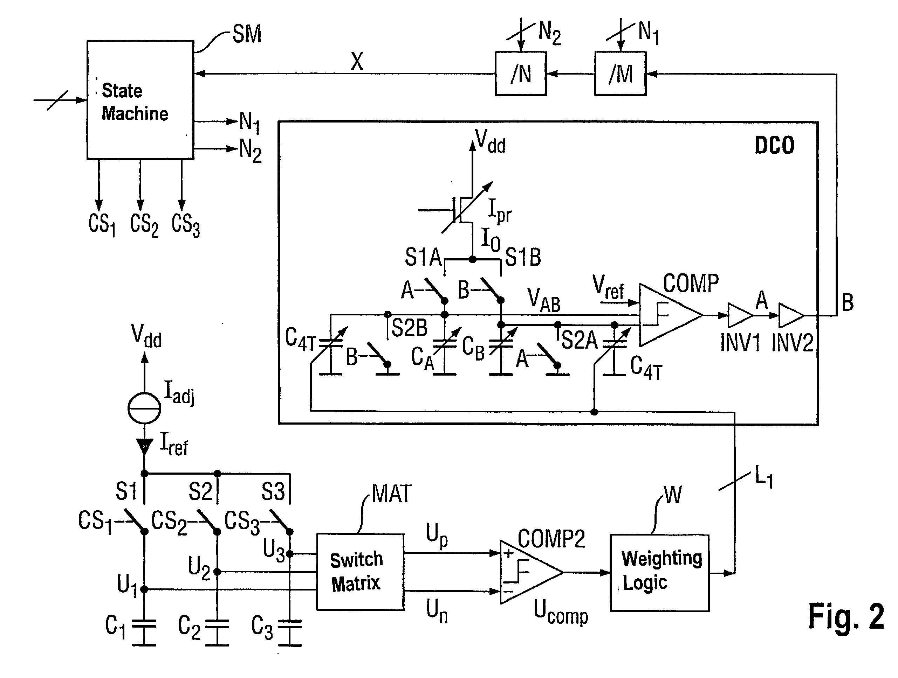

Figure 2 shows a specific implementation of the frequency monitoring stage FMS. The components of the DCO are identical to those shown in Figure 1 and will not be described further. In this embodiment, the clock divider %N is implemented as two clock dividers /M and /N connected in series, with the first clock divider /M being directly connected to the output of the second inverter INV2. The divided frequency X is then output from the second clock divider /N and fed to the input of a state machine SM. The state machine SM has several outputs. Two of the outputs are connected to control inputs of the clock dividers /M and /N, and are operable to provide control signals N1 and N2 to the control inputs of the clock dividers /M and /N, respectively. A further three outputs are connected to three switches S1, S2 and S3 and are operable to output control signals CS1, CS2 and CS3 to the three switches S1, S2 and S3, respectively, for controlling switching of the switches S1, S2 and S3. The switches S1, S2 and S3 are connected in parallel with each other between an adjustable current source ladj and three capacitors C1, C2 and C3, respectively, so that the capacitors C1, C2 and C3 are respectively switched by the switches S1, S2 and S3. The adjustable current source ladj is also connected to the supply voltage rail Vdd. The adjustable current source can be implemented by a single resistor, which can preferably implemented externally to an integrated circuit incorporating the other components. Such an external resistor can be adjusted easily for calibration purposes. Three nodes interconnecting the switches S1, S2 and S3 with the capacitors C1, C2 and C3, respectively, are each connected to a switch matrix. The nodes U1, U2 and U3 represent the voltage across the capacitors C1, C2 and C3, respectively. The switch matrix has two outputs Up and Un, with Up being connected to the positive input of a second comparator COMP2 and Un being connected to the negative input of the second comparator COMP1. The output of the second comparator COMP2 is connected to a weighting logic stage W and is adapted to output a signal Ucomp. The output of the weighting logic stage W is connected via the bus to the control inputs of the variable capacitors CA and CB in the DCO.

The six graphs of the voltages U1, U2, U3, Up, Un and Ucomp in the frequency monitoring stage against time, below the graph of divided output frequency X, in Figures 3 and 4 show how the frequency monitoring stage of the second embodiment works. Figure 3 shows the DCO under stable conditions and Figure 4 shows the DCO when there is a drift in the output frequency due to, for example, temperature changes. The three calibration capacitors C1, C2 and C3 are successively charged using a reference current Iref provided by the adjustable current source ladj, which is ramped up over a period of the divided clock signal to a respective maximum voltage level so that the nodes U1, U2 or U3 are at the maximum voltage level of the respective capacitor C1, C2 or C3. In Figures 3 and 4, the voltage at the node U1 is ramped up to its maximum voltage level over the first clock period of the divided output signal X, by closing the switch S1 using the control signal CS1 from the state machine SM and leaving switches S2 and S3 open so that the capacitor C1 is charged with the reference current Iref, so that the maximum voltage level at the node U1 is reached and maintained for the duration of the output clock signal. For the second clock period of the output clock signal X, the voltage at the node U2 is ramped up to a maximum level following the same procedure as above, by closing the switch S2 using the control signal CS2 so as to charge the capacitor C2 with the reference current Iref. During the third clock period, the voltage at the node U3 is ramped up to a maximum level, by closing the switch S3 with the control signal CS3 and charging the capacitor C3. This process is repeated continuously so that the voltage at the nodes U1, U2 and U3 is consecutively ramped up in a continuous loop.

The switch matrix MAT then consecutively selects two of the maximum voltage levels at U1, U2 or U3, designated Up and Un when they are output from the switch matrix MAT, which are input to the positive and negative inputs of the second comparator COMP2, respectively. From Figures 3 and 4 it can be seen that, after the first period of the divided output clock signal X, the voltage at U3, taken from the previous clock period, is compared with the voltage U1, from the current clock period, so that Up = U3 and Un = U1. The comparator COMP2 compares the two maximum voltage levels Up and Un from the current and previous output clock periods and outputs a signal Ucomp representative of the difference between the two voltage levels Up and Un. The signal Ucomp output from the comparator COMP2 is then input to the weighting logic stage W. A counter can be provided in the weighting logic stage W, which is then either increased or decreased in response to the output of the comparator COMP2. The capacitance of the capacitors CA and CB are varied up or down in response to the counter output, so that the output signal of the DCO is maintained at a constant frequency. Additional weighting steps may be applied to the counter value for improved performance. In Figure 3, when the DCO is operating under ideal, stable conditions, the frequency of the divided DCO output signal X is constant, therefore the voltages Up and Un are always equal and opposite to each other and cancel each other out when compared by the comparator COMP2. The output of the comparator COMP2 is then always zero, the counter in the weighting logic stage W does not count up and down and the capacitance of the capacitors CA and CB in the DCO remains constant. However, as shown in Figure 4, when the DCO is operating under unstable temperature conditions, as the output frequency drifts, so that the time period between output signals increases, the control signals CS1, CS2 and CS3 output from the state machine SM cause the switches S1, S2 and S3 to respectively remain closed for progressively longer periods of time. The ramps of U1, U2, and U3 still have the same slope, but they increase for a longer time. The increase exceeding the ideal maximum voltage is indicate with a filled area on top of each of the voltages. This means that the maximum voltage at the nodes U1, U2 and U3 gets larger for each consecutive clock period. For the example shown in Figure 4, the difference between the voltages Up and Un at the output of the comparator is -1 for each consecutive clock period. In response to the comparator result, the counter in the weighting logic stage may then count down by 1 unit each clock period, decreasing the capacitance of the capacitors CA and CB, and thereby correcting the frequency drift of the output signal of the DCO.

The circuit according to the present invention establishes a self-regulating DCO, the characteristics of which can be adapted to any specific system requirements. The parameters of the circuitry, as for example the clock dividers, the capacitance of the capacitors, the magnitude of the currents, can be easily determined by empirical studies or simulations.

Although the present invention has been described with reference to specific embodiments, it is not limited to these embodiments and no doubt further alternatives will occur to the skilled person that lie within the scope of the invention as claimed.

## Claims

1. A digital controlled oscillator (DCO), comprising:
a programmable current source (Ipr);
a first variable capacitor (CA) and a second variable capacitor (CB);
a first comparator (COMP) operable to compare the voltage drop across the first and second variable capacitors (CA, CB) with a reference voltage level (Vref) and to generate a DCO output clock signal (B) corresponding to the comparison.
switching means (S1A, S1B, S2A, S2B) operable to alternately switch a charging one of the first and second variable capacitors (CA, CB) to receive either a current (I₀) from the programmable current source (Ipr) or to be discharged in response to an output signal of the first comparator (COMP);
a clock divider (%N) coupled to an output of the comparator (COMP) for dividing the DCO output clock signal (B) by a predetermined factor N substantially greater than 1, in order to generate a divided clock signal (X);
a frequency monitoring stage (FMS) arranged to receive the divided clock signal (X) and operable to determine the time difference of successive clock periods of the divided clock signal and to generate a feedback signal based on the determined time difference, the frequency monitor (FMS) being further operable to compare pairs of consecutive clock periods of the divided clock signal, such that each clock period of the divided clock signal is compared with a preceding clock period and with a following clock period of the divided clock signal;
and wherein the frequency monitor (FMS) includes:
an adjustable constant current source (ladj),
three calibration capacitors (C1, C2 C3),
a second comparator (COMP2),
a second switching means (S1, S2, S3) to alternately couple one of the three calibration capacitors (C1, C2 C3) to the adjustable current source (ladj), and two of the three calibration capacitors (C1, C2 C3) to the second comparator (COMP2) in order to compare the voltage levels on the calibration capacitors, and
a controlling means (CNTL) for controlling the second switching means (S1, S2, S3) such that either of the three calibration capacitors (C1, C2 C3) is successively charged with a current from the adjustable current source (ladj) over a period of the divided clock signal to a respective maximum voltage level (U1, U2, U3) and two maximum voltage levels (U1, U2, U3) of two of the three calibration capacitors (C1, C2 C3) are consecutively selected and compared by the second comparator (COMP2) In each clock period of the divided clock signal;
wherein the feedback signal is coupled to the first and second variable capacitors (CA, CB) and the capacitance values of the first and second variable capacitors (CA, CB) are changed in response to the feedback signal in order to adjust the frequency of the DCO output clock signal (B).

2. The digital controlled oscillator (DCO) according to claim 1, wherein the factor N is selected such that a period of the divided clock signal is in proportion to a temperature or supply voltage induced deviation of the DCO output clock signal.

3. The digital controlled oscillator (DCO) according to claim 1, further comprising a weighting stage (W) coupled between a output of the second comparator (COMP2) and the variable capacitors (CA, CB) for weighting the output signal of the second comparator (COMP2) so as to change the capacitance values of the first and second variable capacitors (CA, CB).

4. The digital controlled oscillator (DCO) according to claim 3, wherein the weighting stage (W) includes a counter which is increased and decreased in response to the output of the second comparator (COMP2).

5. The digital controlled oscillator (DCO) according to any preceding claim, wherein each of the first and second variable capacitors (CA, CB) comprises two portions, a first portion, the capacitance of which is adjusted in response to the feedback signal and a second portion with a constant capacitance.

## Patentansprüche

1. Ein digitaler gesteuerter Oszillator (DCO) bestehend aus:
einer programmierbaren Stromquelle (Ipr);
einem ersten regelbaren Kondensator (CA) und einem zweiten regelbaren Kondensator (CB);
einem ersten Komparator (COMP) fonktionell, um den Spannungsabfall über die ersten und zweiten regelbaren Kondensatoren (CA, CB) mit einem Referenzspannungspegel (Vref) zu vergleichen und um ein DCO-Ausgangstaktsignal (B) in Bezug auf den entsprechenden Vergleich bereitzustellen;
einem Schaltmittel (S1A, S1B, S2A, S2B) fonktlonell, um einen entladenden Ein der ersten und zweiten regelbaren Kondensatoren (CA, CB) abwechselnd zu schalten, damit sie entweder einen Strom (I₀) von der programmierbaren Stromquelle (Ipr) empfangen oder In Reaktion auf ein Ausgangssignal des ersten Komparators (COMP) entladen werden;
einem Taktteiler (%N) wird mit dem Ausgang des Komparators (COMP) gekoppelt, um das DCO-Ausgangstaktsignal (B) durch einen vorbestimmten Faktor N zu teilen, der wesentlich grösser als 1 ist, um ein getelltes Taktsignal (X) bereitzustellen;
einer Frequenzüberwachingsstufe (FMS) konfiguriert, um das geteilte Taktsignal (X) zu empfangen und fonktionell, um die Zeitdifferenz zwischen aufeinander folgenden Taktperioden des geteilten Taktsignals zu bestimmen, und ein Rückkopplungssignal in Reaktion auf die bestimmte Zeitdifferenz zu erzeugen, der FMS weiter fonktionell, um Paare von vorlaufenden Taktperioden des geteilten Taktsignals zu vergleichen, damit jeder Taktperlode eines geteilten Taktsignals mit einem vorhergehenden Taktsignal verglichen wird und auch mit einem folgenden Taktperlode des geteilten Taktsignals;
und wobei die Frequenzüberwachungsstufe (FMS) einschließt:
eine regelbaren Konstanstromquelle (ladj)
drei Kallbrierungskondensatoren (C1, C2, C3) einen zweiten Komparator (COMP2)
ein Schaltmittel (S1, S2, S3), um abwechselnd einen der drei Kallbrierungskondensatoren (C1, C2, C3) mit der regelbaren Stromquelle (ladj) und zwei der drei Kalibrierungskondensatoren (C1, C2, C3) mit dem zweiten Komparator (COMP2) zu koppeln, um die Spannungspegel in den Kalibrierungskondensatoren zu vergleichen; und
ein Steuermittel (CNTL) zur Steuerung des zweiten Schaltmittels (S1, S2, S3) derart, dass ein beliebiger der drei Kallbrierungskondensatoren (C1, C2, C3) während einer Periode des geteilten Taktsignals hintereinander mit einem Strom aus der regelbaren Stromquelle (ladj) auf einen entsprechenden Maximalspannungspegel (U1, U2, U3) geladen wird, und es werden in jeder Taktperiode des getellten Takts zwei Maximalspannungspegel (U1, U2, U3) von zwei der drei Kallbrierungskondensatoren (C1, C2, C3) hintereinander ausgewählt und durch den Komparator (COMP2) verglichen;
wobei das Rückkopplungssignal zum ersten und zweiten regelbaren Kondensatoren (CA, CB) gekoppelt wird, und die Kapazitätswerte der ersten und zweiten regelbaren Kondensatoren (CA, CB) als Reaktion auf das Rückkopplungssignal geändert werden, um die Frequenz des DCO-Ausgangstaktsignals (B) einzustellen.

2. Der digitalen gesteuerten Oszillator (DCO) nach Anspruch 1, wobei der Faktor N so gewählt wird, dass eine Periode des geteilten Taktsignals (X) proportional zu einer durch eine Temperature oder eine Versorgungsspannung verursachten Schwankung des DCO-Ausgangstaktsignals ist.

3. Der digitalen gesteuerten Oszillator (DCO) nach Anspruch 1 dazu einschließt eine zwischen den Ausgang des zweiten Konparators (COMP2) und den regelbaren Kondensatoren (CA, CB) gekoppelte Gewichtungsstufe (W) zur Gewichtung des Ausgangssignals des zwelten Komparators (COMP2).

4. Der digitalen gesteuerten Oszillator (DCO) nach Anspruch 3, wobei die Geiwchtungsstufe (W) einen Zähler enthält, der als Reaktion auf das Ausgangssignal des Komparators (COMP2) erhöht und herabgesetzt wird.

5. Der digitalen gesteuerten Oszillator (DCO) nach Jeden vorhergehenden Ansprüchen, wobei Jeder der regelbaren Kondensatoren zwei Abschnitte umfasst, einen ersten Abschnitt, dessen Kapazität als Reaktion auf ein Rückkopplungssignal eingestellt wird, und einen zweiten Abschnitt mit einem konstanten Kapazitätswert.

## Revendications

1. Un oscillateur à commande numérique (DCO) comprenant :
une source de courant programmable (Ipr) ;
un premier condensateur variable (CA) et un deuxième condensateur variable (C2) ;
un premier comparateur (COMP) capable de comparer une chute de tension à travers les premier et deuxième condensateurs variables (CA, CB) avec un niveau de tension de référence (Vref) et de générer un signal d'horloge de sortie DCO (B) correspondant à la comparaison;
les moyens pour commuter (S1A, S1B, S2A, S2B) capables de commuter alternativement un chargeant un des premier et deuxième condensateurs variables (CA, CB) pour recevoir soit un courant (I₀) de la source de courant programmable (Ipr) ou pour être déchargés en réponse à un signal de sortie du premier comparateur (COMP) ;
un diviseur d'horloge (%N) couplé à une sortie du comparateur (COMP) pour diviser le signal d'horloge de sortie DCO (B) par un facteur déterminé d'avance N qui est pour la plupart plus grand que 1, pour générer un signal d'horloge divisé (X) ;
une phase de monitoring de fréquence (FMS) configurée pour recevoir un signal d'horloge divisé (X) et capable de déterminer le décalage entre les périodes d'horloge successives du signal d'horloge divisé et de générer un signal de feedback basé sur le décalage déterminé, le FMS étant capable en plus de comparer les paires de périodes d'horloge successives du signal d'horloge divisé, afin que chaque période d'horloge du signal d'horloge divisé soit comparée avec une période d'horloge précédente et avec une période d'horloge suivante du signal d'horloge divisé;
et où le FMS comprend :
une source de courant constante réglable (ladj) trois condensateurs de talonnage (C1, C2, C3) un deuxième comparateur (COMP2)
un deuxième moyen pour commuter (S1, S2, S3) pour coupler alternativement un des trois condensateurs (C1, C2, C3) à la source de courant réglable (ladj), et deux des trois condensateurs de talonnage (C1, C2, C3) au deuxième comparateur (COMP2) pour comparer les niveaux de tension sur les condensateurs de talonnage, et
un moyen de réglage (CNTL) pour régler le deuxième moyen pour commuter (S1, S2, S3) afin que n'importe des trois condensateurs de talonnage (C1, C2, C3) soit successivement chargé avec un courant de la source de courant réglable (ladj) pendant une période du signal d'horloge divisé à un niveau de tension maximum respectif (U1, U2, U3) et les deux niveaux de tension maximum (U1, U2, U3) des deux des trois condensateurs de talonnage (C1, C2, C3) sont consécutivement sélectionnés et comparés par le deuxième comparateur (COMP2) dans chaque période d'horloge du signal d'horloge divisé ;
où le signal de feedback est couplé aux premier et deuxième condensateurs réglables (CA, CB) et les capacités des premier et deuxième condensateurs réglables (CA, CB) sont réglés en réponse au signal de feedback pour régler la fréquence du signal d'horloge de sortie DCO (B).

2. L'oscillateur à commande numérique (DCO) selon la revendication 1, où le facteur N est sélectionné afin qu'une période du signal d'horloge divisé est proportionnelle à la température ou une déviation causée par une tension d'alimentation du signal d'horloge de sortie DCO.

3. L'oscillateur à commande numérique (DCO) selon la revendication 1, comprend en outre une phase de pondération (W) couplée entre une sortie du deuxième comparateur (COMP2) et les condensateurs réglables (CA, CB) pour pondérer le signal de sortie du deuxième comparateur (COMP2) pour commuter les capacités des premier et deuxième condensateurs réglables (CA, CB).

4. L'oscillateur à commande numérique (DCO) selon la revendication 3, où la phase de pondération (W) comprend un compteur qui est augmenté et diminué en réponse à la sortie du deuxième comparateur (COMP2).

5. L'oscillateur à commande numérique (DCO) selon les revendications précédentes, où chaqu'un des premier et deuxième condensateurs (CA, CB) comprend deux parties, une première partie dont la capacité est réglée en réponse au signal de feedback et une deuxième partie avec une capacité constante.
